Europäisches Patentamt

European Patent Office

Office européen des brevets

(19)

(11) Publication number: **0 050 484**

**B1**

(12) **EUROPEAN PATENT SPECIFICATION**

(45) Date of publication of patent specification: **05.02.86**

(51) Int. Cl.⁴: **G 11 C 11/40**

(21) Application number: **81304818.8**

(22) Date of filing: **15.10.81**

(54) **Sense amplifier circuit.**

(30) Priority: **15.10.80 JP 144162/80**

(43) Date of publication of application:
**28.04.82 Bulletin 82/17**

(45) Publication of the grant of the patent:
**05.02.86 Bulletin 86/06**

(84) Designated Contracting States:
**DE FR GB NL**

(56) References cited:
**EP-A-0 015 070**
**US-A-4 110 842**
**US-A-4 136 292.**

(73) Proprietor: **FUJITSU LIMITED**
**1015, Kamikodanaka Nakahara-ku**
**Kawasaki-shi Kanagawa 211 (JP)**

(72) Inventor: **Oritani, Atsushi**
**37-22, Nakakibogaoka Asahi-ku**
**Yokahoma-shi Kanagawa 241 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

## Description

The present invention relates to a sense amplifier circuit which is, for example, used in a MIS static random access memory (RAM).

In general, a MIS static RAM cell comprises a bistable flip-flop circuit which uses four or six transistors per bit. That is, the memory cell comprises a pair of driver transistors which are cross-coupled to each other, a pair of load resistors or load transistors, and a pair of transfer transistors connected to one word line and to one pair of bit lines. In this memory cell, only one of the driver transistors is turned on to correspond to memory data "1" or "0". In order to read the cell, the transfer transistors are turned on by changing the potential of the word line and the data on the driver transistors is transferred to the bit lines. In this memory, a sense amplifier circuit is provided for sensing and amplifying a small difference in potential between the bit line pair.

One conventional sense amplifier circuit used in a MIS static RAM comprises a differential amplifier for sensing and amplifying a small difference in potential across a bit line pair, and a pull-down circuit for establishing a reference potential for the differential amplifier. In this case, the pull-down circuit is controlled by a power supply or a voltage which is derived from the power supply. However, in this conventional sense amplifier circuit, when the potential of the power supply is increased, the respective potentials of the bit line pair are thereby caused to increase in phase with one another, while the reference potential for the differential amplifier is unchanged or decreased. As a result, the difference between the potentials of the bit line pair and the reference potential is increased, which brings about a deterioration in the sensing performance of the sense amplifier circuit. In other words, the sensing operation is susceptible to fluctuation in the power supply. In particular, in a highly-integrated memory wherein the cell area thereof is small, the conductance gm of the driver transistors is small, so that the difference in potential across the bit line pair is very small. As a result, the sensing operation is very susceptible to fluctuation in the power supply.

It is desirable to provide a sense amplifier which is relatively stable in operation when the potential of a power supply fluctuates.

With a view to providing such an improvement, the present invention is concerned with a sense amplifier which comprises first and second supply lines; first and second input lines; first and second output lines; a differential amplifier, for sensing and amplifying difference in potential between the said first and second input lines thereby to deliver, by way of the said output lines, bipolar signals which differ from one another in potential in dependence upon the said difference in potential between the said input lines, which differential amplifier comprises a first input transistor, having a drain connected to the said first power supply line by way of a first load and to the said first output line and having a gate connected to the said first input line, and a second input transistor, having a drain connected to the said first power supply line by way of a second load and to the said second output line and having a gate connected to the said second input line; pull-down circuitry connected from respective sources of the said first and second input transistors to the said second power supply line, for establishing a reference potential for the said differential amplifier; and compensation circuitry connected for controlling the conductance of the said pull-down circuitry and comprising a third load, connected at one end to the said first power supply line and at its other end to the said pull-down circuitry, and transistor means having a source/drain path connected between the said third load and the said second power supply line.

US—A—4,110,842 discloses such a sense amplifier, using compensation circuitry in which the said third load comprises two transistors in parallel with one another and having respective gates connected individually to the said first and second output lines so as to provide a feed-back arrangement in which the effects of differential signals on the two output lines are balanced out but the resulting feed-back can provide some compensation for such disturbing factors as supply voltage and temperature variations. However, this has no bearing on the solution of the present problem, namely the important effect that in-phase variations of the signals on the input lines can have on the operation of the amplifier. Insofar as there might be a relevant fortuitous feedback effect in this prior circuitry, the fact that the reference potential provided by the pull-down circuitry varies with current therethrough will tend to reduce substantially the effective transfer of in-phase components of signal variation from the input lines to the output lines, so that in this prior circuitry the feed-back loop gain for the in-phase components of the input line signals will be so low as to be relatively ineffectual. Furthermore, the prior circuitry uses a source-follower configuration in its compensation circuitry. Such source-follower circuitry, using MOS transistors, is known to suffer from the defect that the source output potential does not closely follow the gate input potential; that is to say, the feed-back effect is relatively low.

Attention has also been drawn to EP—A—0 015 070, which discusses the control of reference transistors in differential amplifiers by applying to those transistors the input and/or output signals of the differential amplifiers. However, this again fails to realise the importance of the in-phase components of the input signals.

Input signals in this prior circuitry are fed also, in one example, directly to the gates of respective pull-down transistors to provide a form of feed-back. In consequence, when an input signal rises, the "feedback" provided thereby will cause the associated reference voltage to fall, which will

again produce a deterioration in the sensing performance (speed) of the differential amplifier.

The present invention is characterised in that the aforesaid transistor means of the compensation circuitry comprise first and second transistors having respective drains connected in common to the said third load and having respective sources connected in common to the said second power supply line and having respective gates which are connected individually to the said input lines, whereby the said conductance of the pull-down circuitry is controlled in dependence upon in-phase components of the respective potentials of the said input lines when the sense amplifier is in use.

It will be recognised that such compensation circuitry comprises an OR-coupled inverter configuration (otherwise known as a source-grounded transistor configuration), which is well known to provide a high feed-back effect.

Reference will now be made, by way of example, to the accompanying drawings, in which:—

Fig. 1 is a circuit diagram illustrating one conventional sense amplifier circuit applied to a MIS static RAM;

Figs. 2 and 3 are diagrams for explaining the operation of the circuit of Fig. 1;

Fig. 4 is a circuit diagram of a first embodiment of the sense amplifier circuit according to the present invention, applied to a MIS static RAM;

Fig. 5 is a diagram for explaining the operation of the circuit of Fig. 4;

Figs. 6, 7 and 8 are circuit diagrams illustrating second, third and fourth embodiments of the sense amplifier circuit according to the present invention, respectively.

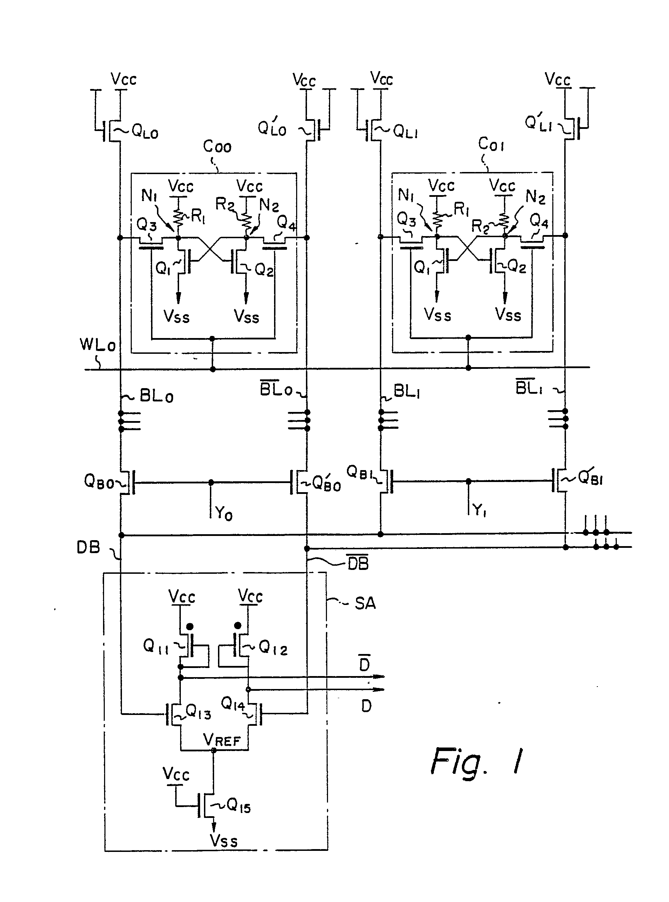

In Fig. 1, which illustrates one conventional sense amplifier circuit applied to a MIS static RAM, $C_{00}$ and $C_{01}$ are memory cells; $WL_0$ is a word line; $BL_0$, $\overline{BL_0}$, $BL_1$ and $\overline{BL_1}$ are bit lines; $Q_{L0}$, $Q_{L0}'$, $Q_{L1}$ and $Q_{L1}'$ are load transistors connected to a power supply; $Q_{B0}$, $Q_{B0}'$, $Q_{B1}$ and $Q_{B1}'$ are column selection transistors which are selected by column selection signals $Y_0$ and $Y_1$; DB and $\overline{DB}$ are data bit lines; and SA is a sense amplifier circuit connected to the data bit lines DB and $\overline{DB}$.

Each of the memory cells $C_{00}$ and $C_{01}$ comprises resistors $R_1$ and $R_2$, driver transistors $Q_1$ and $Q_2$ with drains and gates cross-coupled, and transfer transistors $Q_3$ and $Q_4$.

In the sense amplifier circuit SA, a differential amplifier, which is formed by depletion type load transistors $Q_{11}$ and $Q_{12}$ and enhancement type input transistors $Q_{13}$ and $Q_{14}$, senses and amplifies the difference in potential between the data bit lines DB and $\overline{DB}$ and generates bipolar differential signals D and $\overline{D}$. A pull-down circuit formed by an enhancement transistor $Q_{15}$ determines a reference potential $V_{REF}$ of the differential amplifier. Note that, a power supply $V_{CC}$ is applied to the gate of the transistor $Q_{15}$.

The operation of the circuit of Fig. 1 will now be explained. For example, when the data stored in the cell $C_{00}$ is read out, the potential of the word line $WL_0$ is caused to be high by a word decoder/driver (not shown) so as to turn on the transfer transistors $Q_3$ and $Q_4$, and simultaneously, or after that, the potential of the column selection signal $Y_0$ is caused to be high so as to turn on the transistors $Q_{B0}$ and $Q_{B0}'$. At this time, if the state of the cell $C_{00}$ is that the transistors $Q_1$ and $Q_2$ are turned on and off, respectively, that is, the potentials at nodes $N_1$ and $N_2$ are low and high, respectively, the potentials of the bit lines $BL_0$ and $\overline{BL_0}$ become low and high, respectively. In addition, the potentials of the data bit lines DB and $\overline{DB}$ also become low and high, respectively. Therefore, the difference in potential between the data bit lines DB and $\overline{DB}$ are sensed and amplified by the sense amplifier SA so that the differential signals D and $\overline{D}$ are obtained.

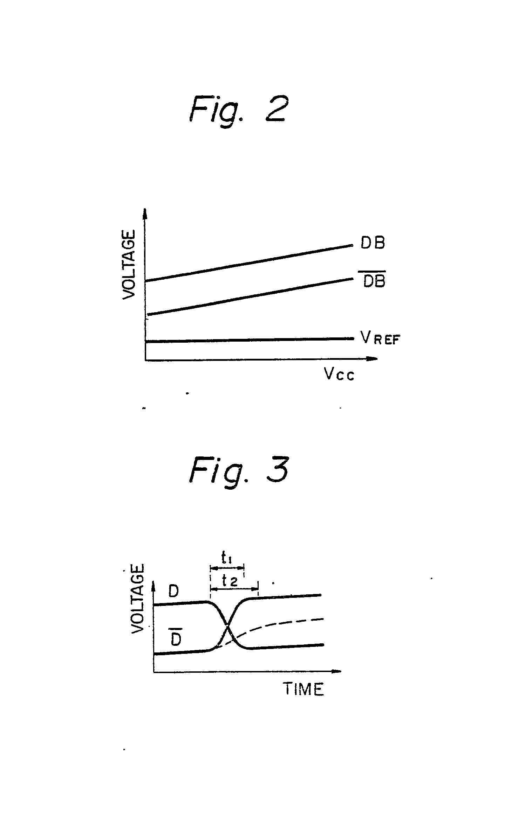

In this state, when the power supply $V_{CC}$ is fluctuated, for example, when the potential of the power supply $V_{CC}$ is increased, the potentials of the data bit lines DB and $\overline{DB}$ are also increased, as illustrated in Fig. 2. However, since the gate potential of the transistor $Q_{15}$ is also increased so as to increase the conductivity of the transistor $Q_{15}$, the reference potential $V_{REF}$ is unchanged or becomes a little low. As a result, the difference between the potential of the data bit line DB and the reference potential $V_{REF}$ and the difference between the potential of the data bit line $\overline{DB}$ and the reference potential $V_{REF}$ both become large. At worst, even when the potential of the data bit line $\overline{DB}$ is low, the transistor $Q_{14}$ is not turned off. As a result, as indicated by a broken line in Fig. 3, the high-potential side differential output signal $\overline{D}$ rises slowly, and in additiom, the potential level of the signal $\overline{D}$ is reduced. That is, the access time is changed from an optimum time $t_1$ to a long time $t_2$. Further, at worst, the signals D and $\overline{D}$ are both determined to be low by a subsequent circuit. This is because the in-phase component (or common direct component) of the data bit lines DB and $\overline{DB}$ become large as compared with the differential component thereof. Therefore, the fluctuation tolerance of the power supply $V_{CC}$ is small, and in addition, the access time becomes large and at worst, a read-out error may be generated.

Contrary to this, in the present invention, even when the potential of the power supply $V_{CC}$ is fluctuated, the reference potential $V_{REF}$ is changed in response to the potential fluctuation of the data bit lines DB and $\overline{DB}$ so as to obtain an accurate and high-speed sensing operation.

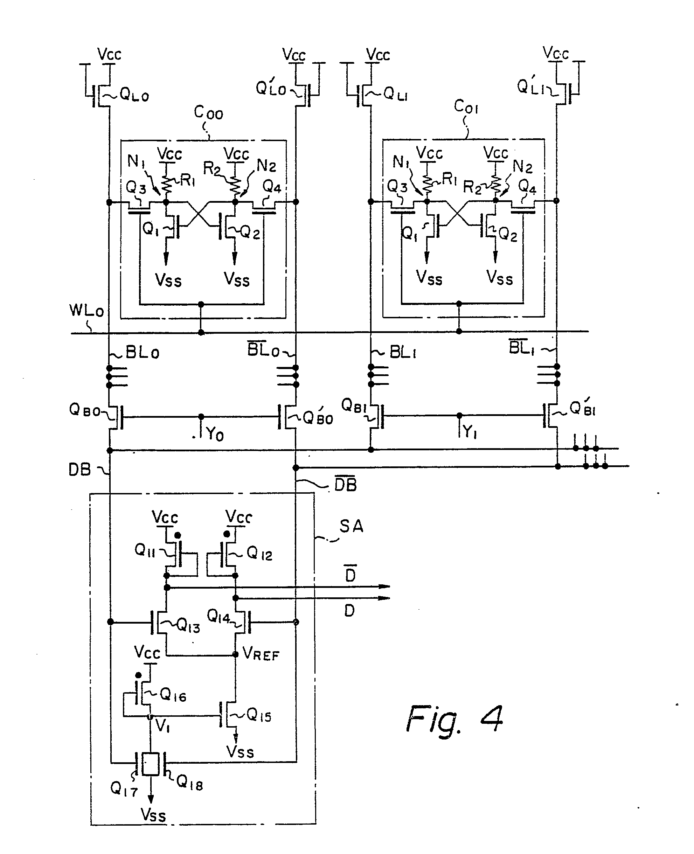

Fig. 4 is a circuit diagram illustrating a first embodiment of the sense amplifier circuit according to the present invention, applied to a MIS static RAM. In Fig. 4, the elements which are the same as those of Fig. 1 are denoted by the same references. In Fig. 4, a compensation circuit formed by a depletion type load transistor $Q_{16}$ and enhancement type transistors $Q_{17}$ and $Q_{18}$ is added to the sense amplifier circuit SA of Fig. 2. In this case, the gates of the transistors $Q_{17}$ and $Q_{18}$ are connected to the data bit lines DB and $\overline{DB}$, respectively, and the transistor $Q_{16}$ is connected

to the power supply $V_{CC}$ and to the transistors $Q_{17}$ and $Q_{18}$. Further, the pull-down circuit formed by the transistor $Q_{15}$ is controlled by the potential $V_1$ at a node connecting the transistor $Q_{16}$ to the transistors $Q_{17}$ and $Q_{18}$.

In the circuit of Fig. 4, when the driver transistors $Q_1$ and $Q_2$ of the selected memory cell $C_{00}$ are turned on and off, respectively, the potentials of the data bit lines DB and $\overline{DB}$ are low and high, respectively. In this case, the differential component of the data bit lines DB and $\overline{DB}$ is suppressed by the compensation circuit formed by the transistors $Q_{16}$, $Q_{17}$ and $Q_{18}$, so that the potential $V_1$ is not changed. That is, if one of the potentials of the data bit lines DB and $\overline{DB}$ is high, then the other is low. Therefore, if one of the transistors $Q_{17}$ and $Q_{18}$ is turned on, then the other is turned off. As a result, the compensation circuit is unchangeable. Therefore, in this case, the pull-down circuit formed by the transistor $Q_{15}$ is controlled by the potential $V_1$ which is constant.

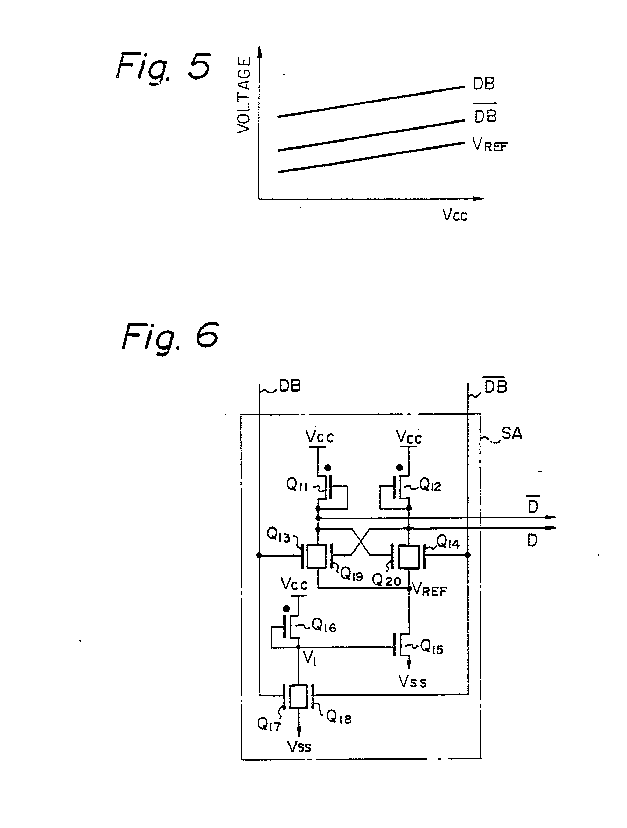

On the other hand, in the circuit of Fig. 4, when the power supply $V_{CC}$ is fluctuated, the in-phase component of the data bit lines DB and $\overline{DB}$ is also fluctuated. For example, as illustrated in Fig. 5, due to the increase of the potential of the power supply $V_{CC}$, the potentials of the data bit lines DB and $\overline{DB}$ are both increased. As a result, the conductances of the transistors $Q_{17}$ and $Q_{18}$ are both increased, and in turn, the potential $V_1$ is decreased. Therefore, the conductance of the transistor $Q_{15}$ is decreased so as to increase the reference potential $V_{REF}$. Therefore, as illustrated in Fig. 5, the difference between the potential of the data bit line DB (or $\overline{DB}$) and the reference potential $V_{REF}$ is always almost constant, regardless of the fluctuation of the power supply $V_{CC}$, so that a stable and high-speed sensing operation is achieved.

Fig. 6 is a circuit diagram illustrating a second embodiment of the sense amplifier circuit according to the present invention. In Fig. 6, a latch circuit formed by transistors $Q_{19}$ and $Q_{20}$ is added to the sense amplifier circuit of Fig. 4. Therefore, when a definite difference in potential between the differential signals D and $\overline{D}$ is generated, the latch operation is rapidly effected.

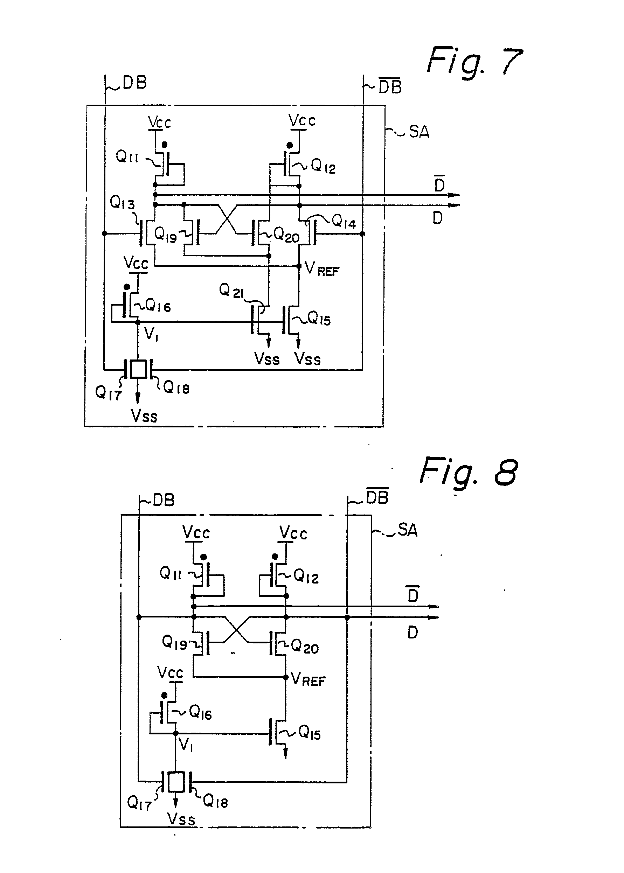

Fig. 7 is a circuit diagram illustrating a third embodiment of the sense amplifier circuit according to the present invention. In Fig. 7, another pull-down circuit formed by a transistor $Q_{21}$ is added to the circuit of Fig. 6. However, the operation of the circuit of Fig. 7 is similar to that of the circuit of Fig. 6.

Fig. 8 is a circuit diagram illustrating a fourth embodiment of the sense amplifier circuit according to the present invention. In Fig. 8, the transistors $Q_{13}$ and $Q_{14}$ are omitted from the circuit of Fig. 6, and in addition the data bit lines DB and $\overline{DB}$ are connected to the output lines for generating the differential output signals D and $\overline{D}$. In Fig. 8, immediately after the latch operation is effected, the transistors $Q_{B0}$ and $Q_{B0}'$ (or $Q_{B1}$ and $Q_{B1}'$) are cut off. As a result, the data stored in the latch circuit formed by the transistors $Q_{19}$ and $Q_{20}$ is not fedback to any memory cells.

In Figs. 4, 6, 7 and 8, each of the load transistors $Q_{11}$, $Q_{12}$ and $Q_{16}$ is of a depletion type; however, this transistor can be of an enhancement type with a drain and a gate coupled.

As explained hereinbefore, the sense amplifier circuit according to the present invention has an advantage, as compared with the conventional circuit, in that a stable sensing operation is performed even when the potential of a power supply is fluctuated, since the reference potential $V_{REF}$ is changed in response to the in-phase component of the input lines (the data bit lines DB and $\overline{DB}$).

## Claims

1. A sense amplifier comprising:
   first and second power supply lines ($V_{CC}$, $V_{SS}$);
   first and second input lines (DB, $\overline{DB}$);
   first and second output lines ($\overline{D}$, D);
   a differential amplifier, for sensing and amplifying difference in potential between the said first and second input lines (DB, $\overline{DB}$) thereby to deliver, by way of the said output lines ($\overline{D}$, D), bipolar signals which differ from one another in potential in dependence upon the said difference in potential between the said input lines, which differential amplifier comprises a first input transistor ($Q_{13}$), having a drain connected to the said first power supply line ($V_{CC}$) by way of a first load ($Q_{11}$) and to the said first output line ($\overline{D}$) and having a gate connected to the said first input line (DB), and a second input transistor ($Q_{14}$), having a drain connected to the said first power supply line ($V_{CC}$) by way of a second load ($Q_{12}$) and to the said second output line (D) and having a gate connected to the said second input line ($\overline{DB}$);
   pull-down circuitry ($Q_{15}$) connected from respective sources of the said first and second input transistors ($Q_{13}$, $Q_{14}$) to the said second power supply line ($V_{SS}$), for establishing a reference potential ($V_{REF}$) for the said differential amplifier; and
   compensation circuitry connected for controlling the conductance of the said pull-down circuitry ($Q_{15}$) and comprising a third load ($Q_{16}$), connected at one end to the said first power supply line ($V_{CC}$) and at its other end to the said pull-down circuitry ($Q_{15}$), and transistor means having a source/drain path connected between the said third load ($Q_{16}$) and the said second power supply line ($V_{SS}$);
   characterised in that the said transistor means comprise first and second transistors ($Q_{17}$, $Q_{18}$) having respective drains connected in common to the said third load ($Q_{16}$) and having respective sources connected in common to the said second power supply line ($V_{SS}$) and having respective gates which are connected individually to the said input lines (DB, $\overline{DB}$), whereby the said conductance of the pull-down circuitry ($Q_{15}$) is controlled in dependence upon in-phase components of the respective potentials of the said input lines (DB, $\overline{DB}$) when the sense amplifier is in use.

2. A sense amplifier as claimed in claim 1, wherein the said third load comprises a depletion type transistor ($Q_{16}$) with a gate and a source coupled together.

3. A sense amplifier as claimed in claim 1, wherein the said third load comprises an enhancement type transistor with a drain and a gate coupled together.

4. A sense amplifier as claimed in any previous claim, wherein the said first and second loads comprise respective depletion type transistors ($Q_{11}$, $Q_{12}$), each having a gate and a source coupled together.

5. A sense amplifier as claimed in any one of claims 1 to 3, wherein the said first and second loads comprised respective enhancement type transistors, each having a drain and a gate coupled together.

6. A sense amplifier as claimed in any preceding claim, wherein the said pull-down circuitry comprises an enhancement type transistor ($Q_{15}$) having a drain connected to the said differential amplifier, a gate connected to the said compensation circuitry and a source connected to the said second power supply line ($V_{SS}$).

7. A sense amplifier as claimed in any preceding claim, wherein the said differential amplifier further comprises latching circuitry formed of first and second enhancement type transistors ($Q_{19}$, $Q_{20}$) with drains and gates cross-coupled, which transistors are connected respectively in parallel with the said first and second input transistors ($Q_{13}$, $Q_{14}$).

8. A sense amplifier as claimed in claim 7, modified in that the said first and second input transistors $Q_{13}$, $Q_{14}$) are omitted and the said first and second enhancement type transistors ($Q_{19}$, $Q_{20}$) have respective drains connected individually to the said input lines (DB, $\overline{DB}$).

9. A sense amplifier as claimed in any one of claims 1 to 6, further comprising second pull-down circuitry ($Q_{21}$), the conductance of which is controlled by the said compensation circuitry, wherein the said differential amplifier further comprises latching circuitry formed of first and second enhancement type transistors ($Q_{19}$, $Q_{20}$) with drains and gates cross-coupled, which transistors are connected respectively from the said first and second loads ($Q_{11}$, $Q_{12}$) to the said second pull-down circuitry ($Q_{21}$).

10. A sense amplifier as claimed in claim 9, wherein the said second pull-down circuitry comprises a further enhancement type transistor ($Q_{21}$) having a drain connected to the said first and second enhancement type transistors ($Q_{19}$, $Q_{20}$), a gate connected to the said compensation circuitry and a source connected to the said second power supply line ($V_{SS}$).

**Revendications**

1. Amplificateur de détection comprenant:

des premier et second fils d'alimentation ($V_{CC}$, $V_{SS}$);

des permier et second fils d'entrée (DB, $\overline{DB}$);

des premier et second fils de sortie $\overline{D}$, D);

un amplificateur différentiel, destiné à détecter et amplifier la différence de potentiel entre les premier et second fils d'entrée (DB, $\overline{DB}$) pour délivrer de la sorte, au moyen des fils de sortie $\overline{D}$, D), des signaux bipolaires qui diffèrent entre eux en tension en fonction de la différence de potentiel entre les fils d'entrée, cet amplificateur différentiel comprenant un premier transistor d'entrée ($Q_{13}$), comportant un drain connecté au premier fil d'alimentation ($V_{CC}$) au moyen d'une première charge ($Q_{11}$) et au premier fil de sortie ($\overline{D}$) et comportant une grille connectée au premier fil d'entrée (DB), et un second transistor d'entrée ($Q_{14}$), comportant un drain connecté au premier fil d'alimentation ($V_{CC}$) au moyen d'une deuxième charge ($Q_{12}$) et au second fil de sortie (D) et comportant une grille connectée au second fil d'entrée ($\overline{DB}$);

un circuit chuteur ($Q_{15}$) connecté entre les sources respectives des premier et second transistors d'entrée ($Q_{13}$, $Q_{14}$) et le second fil d'alimentation ($V_{SS}$), pour établir une tension de référence ($V_{REF}$) pour l'amplificateur différentiel; et

un circuit de compensation connecté pour régler la conductance du circuit chuteur ($Q_{15}$) et comprenant une troisième charge ($Q_{16}$), connecté par une extrémité au premier fil d'alimentation ($V_{CC}$) et par son autre extrémité au circuit chuteur ($Q_{15}$), et un moyen à transistor comportant un chemin de source/drain connecté entre la troisième charge ($Q_{16}$) et la second· fil d'alimentation ($V_{SS}$);

caractérisé en ce que le moyen à transistor comprend des premier et second transistors ($Q_{17}$, $Q_{18}$) comportant des drains respectifs connectés en commun à la troisième charge ($Q_{16}$) et comportant des sources respectives connectées en commun au second fil d'alimentation ($V_{SS}$) et comportant des grilles respectives qui sont connectées séparément aux fils d'entrée (DB, $\overline{DB}$) la conductance du circuit chuteur ($Q_{15}$) étant ainsi réglée en fonction des composantes en phase des tensions respectives des fils d'entrée (DB, $\overline{DB}$) quand l'amplificateur de détection est en fonctionnement.

2. Amplificateur de détection selon la revendication 1, caractérisé en ce que la troisième charge comprend un transistor du type à appauvrissement ($Q_{16}$) dont la grille et la source sont reliées entre elles.

3. Amplificateur de détection selon la revendication 1, caractérisé en ce que la troisième charge comprend un transistor du type à enrichissement dont le drain et la grille sont reliés entre eux.

4. Amplificateur de détection selon l'une quelconque des revendications 1 à 3, caractérisé en ce que les première et deuxième charges comprennent des transistors respectifs du type à

appauvrissement ($Q_{11}$, $Q_{12}$), comportant chacun une grille et une source reliées entre elles.

5. Amplificateur de détection selon l'une quelconque des revendications 1 à 3, caractérisé en ce que les première et deuxième charges comprennent des transistors respectifs du type à enrichissement, comportant chacun un drain et une grille reliés entre eux.

6. Amplificateur de détection selon l'une quelconque des revendications 1 à 5, caractérisé en ce que le circuit chuteur comprend un transistor du tyqe à enrichissement ($Q_{15}$) comportant un drain connecté à l'amplificateur différentiel, une grille connectée au circuit du compensation et une source connectée au second fil d'alimentation ($V_{SS}$).

7. Amplificateur de détection selon l'une quelconque des revendications 1 à 6, caractérisé en ce que l'amplificateur différentiel comprend en outre un circuit de verrouillage constitué par des premier et second transistors du type à enrichissement ($Q_{19}$, $Q_{20}$) dont les drains et les grilles sont à couplage croisé, ces transistors étant connectés respectivement en parallèle avec les premier et second transistors d'entrée ($Q_{13}$, $Q_{14}$.

8. Amplificateur de détection selon la revendication 7, caractérisé en ce qu'il est modifié par le fait que les premier et second transistors d'entrée ($Q_{13}$, $Q_{14}$) sont omis et que les premier et second transistors du type à enrichissement ($Q_{19}$, $Q_{20}$) comportent des drains respectifs connectés séparément aux fils d'entrée (DB, $\overline{DB}$).

9. Amplificateur de détection selon l'une quelconque des revendications 1 à 6, comprenant en outre un second circuit chuteur ($Q_{21}$) dont la conductance est réglée par le circuit de compensation, caractérisé en ce que l'amplificateur différentiel comprend en outre un circuit de verrouillage constitué par des premier et second transistors du type à enrichissement ($Q_{19}$, $Q_{20}$) dont les drains et les grilles sont à couplage croisé, ces transistors étant connectés respectivement entre les première et deuxième charges ($Q_{11}$, $Q_{12}$) et le second circuit chuteur ($Q_{21}$).

10. Amplificateur de détection selon la revendication 9, caractérisé en ce que le second circuit chuteur comprend un autre transistor du type à enrichissement ($Q_{21}$) comportant un drain connecté au premier et second transistors à enrichissement ($Q_{19}$, $Q_{20}$), une grille connectée au circuit de compensation et une source connectée au second fil d'alimentation ($V_{SS}$).

## Patentansprüche

1. Leseverstärker mit:

ersten und zweiten Energieversorgungsleitungen ($V_{CC}$, $V_{SS}$);

ersten und zweiten Eingangsleitungen (DB, $\overline{DB}$);

ersten und zweiten Ausgangsleitungen ($\overline{D}$, D);

einem Differenzverstärker, um eine Potentialdifferenz zwischen den genannten ersten und zweiten Ausgangsleitungen (DB, $\overline{DB}$) zu lesen und zu verstärken, um dadurch mittels der genannten Ausgangsleitungen ($\overline{D}$, D) bipolare Signale zu liefern, welche voneinander in ihrem Potential in Abhängigkeit von der genannten Potentialdifferenz zwischen den genannten Eingangsleitungen differieren, welcher Differenzverstärker einen ersten Eingangstransitor ($Q_{13}$) umfaßt, der eine Drain hat, die mit der genannten ersten Energieversorgungsleitung ($V_{CC}$) über eine erste Last ($Q_{11}$) und mit der genannten Ausgangsleitung ($\overline{D}$) verbunden ist, und der ein Gate hat, das mit der genannten ersten Eingangsleitung (DB) verbunden ist, und einen zweiten Eingangstransistor ($Q_{14}$), der eine Drain hat, die mit der genannten ersten Energieversorgungsleitung ($V_{CC}$) über eine zweite Last ($Q_{12}$) und mit der genannten zweiten Ausgangsleitung (D) verbunden ist, und der ein Gate hat, das mit der genannten zweiten Eingangsleitung ($\overline{DB}$) verbunden ist;

einer pull-down-Schaltung ($Q_{15}$), die von entsprechenden Sourcen der genannten ersten und zweiten Eingangstransistoren ($Q_{13}$, $Q_{14}$) mit der genannten zweiten Energieversorgungsleitung ($V_{SS}$) verbunden ist, um ein Referenzpotential ($V_{REF}$) für den genannten Differenzverstärker zu liefern; und

einer Kompensationsschaltung, die angeschlossen ist, um die Konduktanz der genannten pull-down-Schaltung ($Q_{15}$) zu steuern und eine dritte Last ($Q_{16}$) umfaßt, die mit ihrem einen Ende mit der genannten ersten Energieversorgungsleitung ($V_{CC}$) und mit ihrem anderen Ende mit der genannten pull-down-Schaltung ($Q_{15}$) verbunden ist, und Transistoreinrichtungen, die einen Source/Drain-Weg haben, der zwischen der genannten dritten Last ($Q_{16}$) und der genannten zweiten Energieversorgungsleitung ($V_{SS}$) verbunden ist;

dadurch gekennzeichnet, daß die genannte Transistoreinrichtung erste und zweite Transistoren ($Q_{17}$, $Q_{18}$) umfaßt, die entsprechende Drains haben, die gemeinsam mit der genannten dritten Last ($Q_{16}$) verbunden sind, und die jeweils Sourcen haben, die gemainsam mit der genannten zweiten Energieversorgungsleitung ($V_{SS}$) verbunden sind, und die jeweils Gates haben, die individuell mit den genannten Eingangsleitungen (DB, $\overline{DB}$) verbunden sind, wodurch die genannte Konduktanz der pull-down-Schaltung ($Q_{15}$) in Abhängigkeit von in Phase befindlichen Komponenten der entsprechenden Potentiale der genannten Eingangsleitungen (DB, $\overline{DB}$) gesteuert wird, wenn der Leserverstärker in Betrieb ist.

2. Leseverstärker nach Anspruch 1, bei welchem die genannte dritte Laste einen Transistor ($Q_{16}$) vom Verarmungstyp umfaßt, dessen Gate und Source miteinander verbunden sind.

3. Leseverstärker nach Anspruch 1, bei welchem die genannte dritte Last einen Transistor vom Anreicherungstyp umfaßt, dessen Drain und Gate miteinander verbunden sind.

4. Leseverstärker nach einem der vorhergehenden Ansprüche, bei welchem die genannten ersten und zweiten Lasten jeweils Transistoren ($Q_{11}$, $Q_{12}$) vom Verarmungsstyp umfassen, deren Gate und Source jeweils miteinander verbunden sind.

5. Leseverstärker nach einem der Ansprüche 1 bis 3, bei welchem die genannten ersten und zweiten Lasten jeweils Transistoren vom Anreicherungstyp umfassen, deren Drain und Gate jeweils miteinander verbunden sind.

6. Leseverstärker nach einem der vorhergehenden Ansprüche, bei welchem die genannte pull-down-Schaltung einen Transistor ($Q_{15}$) vom Anreicherungstyp umfaßt, der eine Drain hat, die mit dem genannten Differenzverstärker verbunden ist, ein Gate, das mit der genannten Kompensationsschaltung verbunden ist, und eine Source, die mit der genannten zweiten Energieversorgungsleitung ($V_{SS}$) verbunden ist.

7. Leseverstärker nach einem der vorhergehenden Ansprüche, bei welchem der genannte Differenzverstärker ferner eine Riegelschaltung umfaßt, die aus ersten und zweiten Transistoren ($Q_{19}$, $Q_{20}$) vom Anreicherungstyp gebildet ist, mit über Kreuz verbundenen Drains und Gates, wobei die Transistoren jeweils parallel zu den ersten und zweiten Eingangstransistoren ($Q_{13}$, $Q_{14}$) verbunden sind.

8. Leseverstärker nach Anspruch 7, dadurch modifiziert, daß die genannten ersten und zweiten Eingangstransistoren ($Q_{13}$, $Q_{14}$) fortgelassen sind und die ersten und zweiten Transistoren ($Q_{19}$, $Q_{20}$) vom Anreicherungstyp jeweils Drains haben, die individuell mit den genannten Eingangsleitungen (DB, $\overline{\text{DB}}$) verbunden sind.

9. Leseverstärker nach einem der Ansprüche 1 bis 6, ferner mit einer zweiten pull-down-Schaltung ($Q_{21}$) deren Konduktanz durch die genannte Kompensationsschaltung gesteuert wird, wobei der genannte Differenzverstärker ferner eine Riegelschaltung umfaßt, die aus ersten und zweiten Transistoren ($Q_{19}$, $Q_{20}$) vom Anreicherungstyp gebildet ist, mit über Kreuz verbundenen Drains und Gates, wobei diese Transistoren jeweils von den genannten ersten und zweiten Eingangslasten ($Q_{11}$, $Q_{12}$) mit der genannten zweiten pull-down-Schaltung ($Q_{21}$) verbunden sind.

10. Leseverstärker nach Anspruch 9, bei welchem die genannte zweite pull-down-Schaltung ferner einen Transistor ($Q_{21}$) vom Anreicherungstyp umfaßt, der eine Drain hat, die mit den genannten ersten und zweiten Transistoren ($Q_{19}$, $Q_{20}$) vom Anreicherungstyp verbunden ist, ein Gate, das mit der genannten Kompensationsschaltung verbunden ist, und eine Source, die mit der genannten zweiten Energieversorgungsleitung ($V_{SS}$) verbunden ist.

0 050 484

Fig. 1

0 050 484

Fig. 2

Fig. 3

2

Fig. 4

3

*Fig. 5*

*Fig. 6*

*Fig. 7*

*Fig. 8*